# EUROPÄISCHE PATENTSCHRIFT

(11) **EP 2 357 484 B1**
(45) Veröffentlichungstag und Bekanntmachung des Hinweises auf die Patenterteilung: **13.03.2013**
(21) Anmeldenummer: 10151531.0
(22) Anmeldetag: 25.01.2010
(51) Int. Cl.: G01R 31/02, G01R 31/40

(54) **Verfahren zur Diagnose einer elektrischen Verbindung und Ausgabebaugruppe**
Method for diagnosing an electrical connection and output assembly
Procédé de diagnostic d'une connexion électrique et unité de sortie

(43) Veröffentlichungstag der Anmeldung: 17.08.2011
(73) Patentinhaber: Siemens Aktiengesellschaft, 80333 München (DE)
(72) Erfinder: Fichtlscherer, Martin, 92224 Amberg (DE); Gramolla, Tobias, 92245 Kümmersbruck (DE); Maier, Mario, 92266 Ensdorf (DE)

(56) Entgegenhaltungen:
- DE-A1-102006 004 481
- GB-A- 2 318 935
- GB-A- 2 389 471
- US-A1- 2003 030 447
- US-A1- 2005 083 066
- US-B1- 6 420 877
- US-B1- 7 298 167

## Beschreibung

Die Erfindung betrifft ein Verfahren zur Diagnose einer elektrischen Verbindung zu einer Last, wobei über einen ersten Ausgang einer ersten Ausgabebaugruppe eine erste Spannung und über einen zweiten Ausgang einer zweiten Ausgabebaugruppe eine zweite Spannung zum Ansteuern der Last bereitgestellt wird, in einem ersten Schritt wird dabei eine Prüfung der elektrischen Verbindung in der ersten Ausgabebaugruppe über den ersten Ausgang durchgeführt.

Des Weiteren betrifft die Erfindung eine Baugruppenanordnung zweier redundant verschalteter Ausgabebaugruppen mit einer ersten Ausgabebaugruppe mit einem ersten Ausgang, welcher zum Ansteuern einer Last mit einer ersten Spannung ausgestaltet ist, einem ersten Steuermittel zum Ansteuern eines ersten Schaltmittels, welches den ersten Ausgang schaltet, mit einem ersten Messmittel zum Erzeugen eines Messwertes und einer zweiten Ausgabebaugruppe mit einem zweiten Ausgang, welcher zum Ansteuern der Last mit einer zweiten Spannung ausgestaltet ist, einem zweiten Steuermittel zum Ansteuern eines zweiten Schaltmittels, welches den zweiten Ausgang schaltet, und mit einem zweiten Messmittel.

Derartige Verfahren und Baugruppen werden beispielsweise bei digitalen Ausgabebaugruppen angewendet, wobei die Diagnose der elektrischen Verbindung sich vorzugsweise auf eine Drahtbrucherkennung bezieht. Insbesondere bei sicherheitsgerichteten Einrichtungen, beispielsweise in der Automatisierungstechnik, spielt eine sichere Drahtbrucherkennung eine wichtige Rolle. Zum Einen muss die Sicherheit für den Prozess gewährleistet sein und zum Anderen muss Sicherheit für Leib und Leben, beispielsweise von den den prozessbedienenden Menschen gewährleistet sein. Bei diesen Sicherheitsanwendungen spielt weiterhin eine redundante Verschaltung der Ausgabebaugruppen eine weitere wichtige Rolle. Redundanz bedeutet im Umfeld der Automatisierungstechnik das Vorhandensein funktional gleicher oder vergleichbarer Ressourcen eines technischen Systems, wenn diese bei einem störungsfreien Betrieb im Normalbetrieb nicht benötigt werden. Um einen redundanten Betrieb zu gewährleisten sind also wenigstens zwei Systeme bzw. zwei Ausgabebaugruppen vorhanden.

Ausgehend von einem redundant verschalteten System von zwei Automatisierungsbaugruppen ist nach dem Stand der Technik bekannt, dass beispielsweise zwei digitale Ausgabebaugruppen zum Treiben einer Last, an der Last mit ihren Ausgängen parallel verschaltet sind, so dass, falls eine Ausgabebaugruppe ausfällt die Stromübernahme für die Last durch die andere Baugruppe gewährleistet ist. Beide Ausgabebaugruppen sind dabei mit einer Drahtbrucherkennung ausgestattet. Für den Fall, dass eine der beiden Baugruppen einen Drahtbruch zur Last erkennen sollte, meldet sie dies über eine separate Kommunikationsschnittstelle zwischen den redundant verschalteten Ausgabebaugruppen der anderen Baugruppe. Es ist dabei von Nachteil, dass zwischen den Baugruppen eine zusätzliche Verdrahtung für die Kommunikation aufgebracht werden muss. Da die genannten Baugruppen auch mit einer Betriebsspannung versorgt werden müssen, ist es weiterhin von Nachteil, dass bei der redundanten Verschaltung, insbesondere bei Schwankungen der Versorgungsspannungen, es dazu kommen kann, dass vorzeitig eine Drahtbrucherkennung diagnostiziert werden kann, obwohl kein wirklicher Drahtbruch vorliegt.

Aus der GB 2 389 471 A ist ein redundantes Spannungsversorgungssystem mit einer Drahtbruchprüfung mit den oben genannten Nachteilen bekannt.

Aus der US 2003/0030447 A1 ist eine Unterbrechungsdetektionsvorrichtung bekannt, welche einen Spannungseinbruch an einem Widerstand in einem Versorgungspfad überwacht.

Es ist Aufgabe der vorliegenden Erfindung bei redundant verschalteten Ausgabebaugruppen auf eine zusätzliche Verdrahtung zur Kommunikation zwischen den beiden Baugruppen zu verzichten.

Eine Lösung für dieses Verfahren ist mit den Merkmalen des Anspruchs 1 gegeben. Bei dem Verfahren sind die Ausgabebaugruppen vorzugsweise redundant verschaltet, bei dieser redundanten Verschaltung ist es vorteilhaft, dass wenn die erste Ausgabebaugruppe einen vermeintlichen Fehler, vorzugsweise eine Drahtbrucherkennung, erkannt hat, dass dies nicht sofort zu einen Absetzen einer Störmeldung führt, denn es könnte ja sein, dass die Erkennung des Fehlers fälschlicherweise, beispielsweise aufgrund von Spannungsschwankungen, ausgelöst wurde. Um dieses ausgelöste Fehlersignal des Fehlers sicher zu verifizieren, schaltet die zweite Ausgabebaugruppe für eine vorbestimmte Zeit ihre Spannung an ihrem Ausgang ab, so dass von dieser Ausgabebaugruppe kein Strom mehr durch die Last fließen kann. Für die Zeitdauer der Ausschaltzeit erfolgt die Stromübernahme für die Last durch die erste Ausgabebaugruppe. Für den Fall dass weiterhin Strom fließt, welches mit dem Messmittel ermittelt werden kann, kann die erste Baugruppe sicher sagen, dass kein Drahtbruch vorliegt. Sollte auch während der Ausschaltzeit kein Strom fließen, so ergibt die Auswertung mit dem Prüfkriterium, dass dieses weiterhin erfüllt ist und somit wird eine Störmeldung erzeugt.

In einer vorteilhaften Ausgestaltung des Verfahrens wird für den Fall, dass das Prüfkriterium nicht mehr erfüllt ist, die Fehler erkennung wieder zurückgenommen. Insbesondere bei einem Falschauslösen eines Fehlersignals, beispielsweise durch unterschiedliche Lastspannungen, kleine Lastströme, unabhängig voneinander arbeitende redundante Netzteile, Spannungsabfälle an den Versorgungsleitungen zu der Last, kann dieses Falschauslösen noch einmal geprüft werden und falls doch kein Drahtbruch vorliegt, wird der Fehler für Drahtbruch wieder zurückgenommen und der Prozess kann normal weiterarbeiten. Durch diesen Verfahrensschritt kommt es nicht zu einer unnötigen Prozessunterbrechung für den Fall dass irrtümlicherweise ein Drahtbruch erkannt wurde.

Von weiterem Vorteil ist es, dass während der Zeitdauer der Ausschaltzeit die erste Baugruppe die Ansteuerung der Last übernimmt.

Das Verfahren wird weiterhin dadurch optimiert, dass innerhalb der Zeitdauer der Wartezeit durch eine sich wiederholende Auswertung des Stromes und der daraus gewonnene Messwert dem Prüfkriterium zyklisch unterzogen wird. Sollte ein Fehler irrtümlich erkannt sein, so kann dieser durch zyklisches Testen innerhalb der Wartezeit mehrmals überprüft werden und die Fehlererkennung kann zurückgenommen werden für den Fall dass das Prüfkriterium nicht mehr erfüllt ist. Ein kurzzeitiges Auslösen des Prüfkriteriums kann beispielsweise erfolgen, durch EMV-Störungen oder Spannungsspitzen auf der Leitung.

Vorzugsweise wird als Prüfkriterium eine Unterschreitung des Messwertes unter einen Grenzwert genutzt werden.

Vorteilhafter Weise wird dabei der Messwert aus einem Spannungsabfall an einem Widerstand gewonnen. Der Widerstand wird dabei in den Strompfad der elektrischen Verbindung geschaltet. Solange ein Strom in dem Strompfad zur Last fließt ist der Spannungsabfall an dem Widerstand ausreichend groß und kann als Messwert erkannt werden und beispielsweise über einen Vergleicher geprüft werden ob der Messwert die nötige Größe hat und einen Grenzwert nicht unterschreitet.

In einer besonderen Ausgestaltung des Verfahrens werden die Prüfung der elektrischen Verbindung und die Abschaltung für die Zeitdauer der Ausschaltzeit zyklisch wiederholt. Durch die zyklische Wiederholung weisen die Ausgabebaugruppen ein zeitlich vorbestimmtes Verhalten auf, mit einer gewissen Periodendauer erfolgt also bei einer Ausgabebaugruppe immer wieder ein Abschalten, und ein Durchführen des Prüfkriteriums mit einer maximalen Zeitdauer der Wartezeit. Dieses zeitlich vorbestimmte Verhalten der Baugruppen ist idealerweise phasenverschoben. Aufgrund des zeitlich bekannten, vorbestimmten Ablaufs ist es nicht erforderlich das Prüfkriterium ständig zu prüfen, also eine Drahtbruchüberwachung durchzuführen, welches bedeutet, dass die erste Baugruppe nicht ständig auf Drahtbruch "gepollt" werden muss. Der ersten Baugruppe ist ein Zeitfenster zwischen den Abschaltungen des Ausgangs der zweiten Baugruppe nahezu bekannt bzw. es kann vorausgesagt werden, dass das Abschalten nur innerhalb eines bestimmten Bereiches erfolgen kann, da die Periodendauern vorzugsweise fest eingestellt sind.

Durch dieses gegenseitige Prüfen der Ausgabebaugruppen über die redundant verschalteten elektrischen Versorgungsleitungen zu der Last kann auf eine zusätzliche Kommunikationsverbindung zwischen den Baugruppen verzichtet werden.

Weiterhin wird die eingangs genannte Aufgabe durch eine Baugruppenanordnung nach dem Anspruch 9 gelöst. In einer möglichen Ausgestaltung der Ausgabebaugruppe ist das Steuermittel beispielsweise als ein ASIC Baustein oder als ein Mikrocontroller ausgestaltet, in diesem Mikrocontroller sind das zeitliche Verhalten für die Wartezeit und die zyklische Anwendung des Prüfkriteriums implementiert.

Das Schaltmittel weist einen ersten Schalter und einen zweiten Schalter zum Aufschalten einer Spannungsquelle auf den Ausgang auf. Dabei ist das Steuermittel weiterhin dazu ausgestaltet, den zweiten Schalter für die Zeitdauer der Wartezeit zu schließen und den ersten Schalter zu Öffnen.

Um den Messwert zu ermitteln ist es in einer bevorzugten Ausgestaltung möglich, dass das Messmittel einen Widerstand aufweist, welcher in einer Reihenschaltung zwischen dem ersten Ausgang und dem zweiten Schalter angeordnet ist.

Um einen Spannungsabfall an dem Widerstand zu begrenzen, ist vorzugsweise parallel zum Widerstand eine erste Diode angeordnet. Da zum Prüfen ob ein Fehler vorliegt der Widerstand in den Strompfaden geschaltet werden muss, fällt an diesem Widerstand eine Spannung ab, welche für die zu schaltende Last nicht mehr zur Verfügung steht. Um die Verluste zu begrenzen, ist es von Vorteil die erste Diode parallel zu dem Widerstand zu schalten.

Ein deterministisches Verhalten, also die Kenntnis davon, dass zukünftige Ereignisse durch Vorbedingungen eindeutig festgelegt sind, wird bei der Ausgabebaugruppe vorzugsweise dadurch erreicht, dass das Steuermittel dazu ausgestaltet ist nach einem zeitlich vorbestimmten Verhalten die Schalter derart zu schalten, dass die erste Spannung am ersten Ausgang für eine Zeitdauer einer Ausschaltzeit ausgeschaltet wird, und das diese Ausschaltzeit innerhalb einer Wartezeit für die Drahtbruchprüfung liegt.

Die Zeichnung zeigt ein Ausführungsbeispiel einer erfindungsgemäßen Ausgabebaugruppe, dabei ist in
- FIG 1: eine Baugruppenanordnung zweier redundant verschalteter Ausgabebaugruppen, in
- FIG 2: eine Detaildarstellung der Ansteuerung eines Ausganges und in
- FIG 3: ein zeitliches Verhalten der redundant verschalteten Ausgabebaugruppen dargestellt.

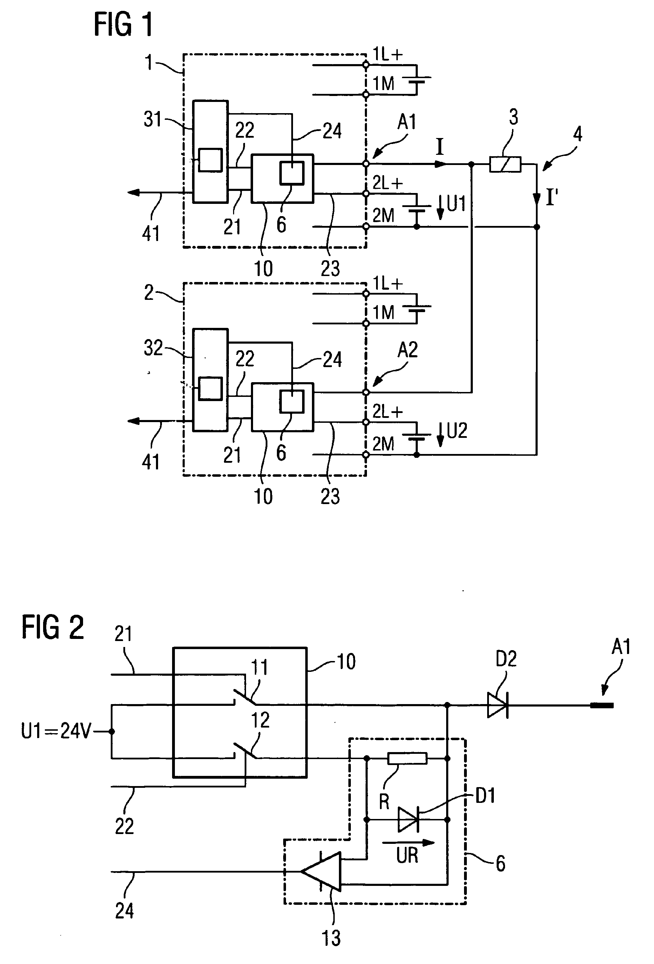

FIG 1 zeigt in schematischer Darstellung eine erste Ausgabebaugruppe 1 mit einem ersten Ausgang A1 und eine zweite Ausgabebaugruppe 2 mit einem zweiten Ausgang A2. Diese Ausgabebaugruppen 1,2 sind mit ihren Ausgängen A1,A2 an einer Last 3 redundant verschaltet. Die Last 3 kann beispielsweise ein Relais, eine LED, ein Feuermelder oder allgemein eine Komponente für eine sicherheitstechnische Anwendung sein. Zu der Last 3 führt eine elektrische Verbindung 4, wobei die elektrische Verbindung 4 eine Verbindung vom ersten Ausgang A1 zur Last 3, eine Verbindung vom zweiten Ausgang A2 zur Last 3, eine Verbindung von der ersten Ausgabebaugruppe 1 von einem Masseanschluss 2M zur Last 3, und eine Verbindung von einem Masseanschluss 2M der zweiten Ausgabebaugruppe 2 umfasst. Durch diese redundante Parallelschaltung ist gewährleistet, dass selbst wenn eine Ausgabebaugruppe 1,2 ausfallen sollte, ein Strom I' durch die Last 3 von der jeweils anderen Ausgabebaugruppe 1,2 übernommen werden kann.

Die Ausgabebaugruppen 1,2 weisen jeweils Anschlüsse für eine Betriebsspannung der Ausgabebaugruppen 1,2 auf. Diese Betriebsspannungsanschlüsse 1L+, 1M sind jeweils an eine Betriebsspannungsquelle angeschlossen. Da die Ausgabebaugruppen 1,2 in ihrem Aufbau identisch ausgelegt sind, wird nachfolgend der prinzipielle innere Aufbau der Ausgabebaugruppen 1,2 am Beispiel der ersten Ausgabebaugruppe 1 erläutert.

Die erste Ausgabebaugruppe 1 weist zum Schalten des ersten Ausgangs A1 ein Schaltmittel 10 auf. Der innere Aufbau des Schaltmittels 10 ist in FIG 2 näher beschrieben. Im Schaltmittel 10 ist zusätzlich ein Messmittel 6 zur Messung eines Stromes I angeordnet. Zur Steuerung des Schaltmittels 10 weist die erste Ausgabebaugruppe 1 ein erstes Steuermittel 31 auf. Das erste Steuermittel 31 ist dazu ausgestaltet, einen Fehler innerhalb des ersten Steuermittels 31 zu vermerken und bei Bestätigung des Fehlers eine Störmeldung 41 abzugeben. Das Schaltmittel 10 weist einen ersten Eingang 21, einen zweiten Eingang 22 und einen dritten Eingang 23 auf. Der erste Eingang 21 dient der Ansteuerung eines ersten Schalters 11 (siehe FIG 2), der zweite Eingang 22 dient der Ansteuerung eines zweiten Schalters 12 (siehe FIG 2) und der dritte Eingang 23 dient dem Anschluss einer ersten Spannung U1, welche über das Schaltmittel 10 über den Ausgang A1 an die Last 3 geschaltet wird. Ein aufgrund der angeschalteten ersten Spannung U1 fließender Strom I kann vom ersten Ausgang A1 über die Last 3 zu einem Masseeingang 2M der ersten Baugruppe und/oder einem Masseeingang 2M der zweiten Ausgabebaugruppe 2 abfließen. Diese Verschaltung stellt die redundante Verschaltung dar.

Ein Diagnoseausgang 24 des Schaltmittels 10 ist mit dem ersten Steuermittel 31 verschaltet und kann somit dem ersten Steuermittel 31 mitteilen, ob es einen Fehler erkannt hat, der sodann im ersten Steuermittel 31 vermerkt wird. Mit dieser Ausgestaltung der ersten Ausgabebaugruppe 1 kann ein Verfahren zum Drahtbruch der elektrischen Verbindung 4 der Last 3, wobei über den ersten Ausgang A1 der ersten Ausgabebaugruppe 1 die erste Spannung U1 und über den zweiten Ausgang A2 der zweiten Ausgabebaugruppe 2 die zweite Spannung U2 zum Ansteuern der Last bereitgestellt wird, durchgeführt werden. Dabei erfolgt eine Prüfung der elektrischen Verbindung 4 in der ersten Ausgabebaugruppe 1 über den ersten Ausgang A1, wobei in der ersten Ausgabebaugruppe 1 der Strom I ausgewertet und ein daraus gewonnener Messwert einem Prüfkriterium unterzogen wird, wobei ein Erfüllen des Prüfkriteriums zunächst in der ersten Ausgabebaugruppe 1 innerhalb des ersten Steuermittels 31 als Fehler vermerkt wird, dabei ist das erste Steuermittel 31 derart ausgestaltet, dass innerhalb einer Zeitdauer einer Wartezeit TW durch eine sich wiederholende Auswertung des Stromes I und der daraus gewonnene Messwert dem Prüfkriterium zyklisch unterzogen wird.

Die zweite Ausgabebaugruppe 2 mit ihrem zweiten Steuermittel 32 ist dabei, beispielsweise durch eine Ausgestaltung des zweiten Steuermittels 32 als ein Mikrocontroller, derart vorbereitet, dass während der sich zyklisch wiederholenden Auswertung des Stromes I in der ersten Ausgabebaugruppe 1, der Mikrocontroller in der zweiten Ausgabebaugruppe 2 sein entsprechendes Schaltmittel 10 derart ansteuert, dass innerhalb einer Zeitdauer der Wartezeit TW die zweite Ausgabebaugruppe 2 derart betrieben wird, dass die zweite Spannung U2 am zweiten Ausgang A2 für eine Zeitdauer einer Ausschaltzeit TA abgeschaltet wird. Dabei wird in der ersten Ausgabebaugruppe 1 der Strom I erneut ausgewertet und ein daraus gewonnener Messwert erneut dem Prüfkriterium unterzogen. Ist das Prüfkriterium weiterhin erfüllt, so setzt die erste Ausgabebaugruppe 1 eine Störmeldung 41 über ihr erstes Steuermittel 31 ab.

Mit anderen Worten gesagt, wird die zweite Spannung U2 an der zweiten Ausgabebaugruppe 2 gänzlich abgeschaltet, so kann ein Stromfluss nur noch durch die erste Ausgabebaugruppe 1 erfolgen, dass bedeutet, wenn weiterhin ein Stromfluss vorliegt, der groß genug ist, so kann kein Drahtbruch vorliegen und der zuvor erzeugte Fehler vermerk kann zurückgenommen werden und es braucht keine Störmeldung 41 für einen Drahtbruch erzeugt werden.

Würde ein Drahtbruch vorliegen, so würde auch während der Ausschaltzeit der zweiten Ausgabebaugruppe 2 kein Strom I über die erste Ausgabebaugruppe 1 fließen und eine Störmeldung 41 könnte generiert werden.

Dieses Verfahren bzw. die Ausgestaltung der Ausgabebaugruppen 1,2 hat den Vorteil, dass bei geringen Lastströmen bzw. unterschiedlichen Versorgungsspannungen es zu einer unterschiedlichen Stromverteilung zwischen beiden Ausgabebaugruppen 1,2 kommen kann und dies kann dazu führen, dass beispielsweise in der ersten Ausgabebaugruppe A1 eine Grenze für die Drahtbrucherkennung unterschritten wird und somit fälschlicher Weise eine entsprechende Diagnose abgesetzt würde. Durch die verfahrensmäßig genannten Schritte wird diese fälschlicher Weise abgesetzte Diagnose überprüft und abgesichert.

Gemäß FIG 2 ist das aus FIG 1 bekannte Schaltmittel 10, der erste Ausgang A1 und das Messmittel 6 im Detail dargestellt. Das Schaltmittel 10 weist einen ersten Schalter 11 und einen zweiten Schalter 12 auf. Der ersten Schalter 11 wird über einen ersten Eingang 21 derart angesteuert, dass er von einer geöffneten Position in eine Schließposition übergehen kann. In dieser Schließposition schaltet er die erste Spannung U1, welche im Beispiel 24 Volt entspricht, an den Ausgang A1. Der zweite Schalter 12 kann entsprechend über einen zweiten Eingang 22 angesteuert werden, so dass auch er von einer Öffnungsposition in eine Schließposition wechselt und ebenfalls die erste Spannung U1 durchschaltet. Aber nun liegt in dem Strompfad zum Ausgang A1 in einer Reihenschaltung zwischen dem zweiten Schalter 12 und dem ersten Ausgang A1 ein Widerstand R. Der Widerstand R ist Bestandteil des Messmittels 6. Ist der zweite Schalter 12 geschlossen, und der erste Schalter 11 geöffnet, so kann bei einem Stromfluss über den Ausgang A1 also auch über den Widerstand R am Widerstand R eine Spannung UR abfallen. Die Spannung UR wird einem Vergleicher 13 zugeführt, welcher die Spannung UR bzw. den durch den Widerstand fließenden Strom auswertet und ihm einem Prüfkriterium unterzieht. Als Prüfkriterium wird eine Unterschreitung des Messwertes des Spannngsabfalles UR unter einen bestimmbaren Grenzwert genutzt. Entspricht der Spannungsabfall UR nicht dem zuvor eingestellten Grenzwert, so ist der Vergleicher 13 dazu ausgestaltet, über einen Diagnoseausgang 24 die Diagnosemeldung abzusetzen.

Um bei der redundanten Verschaltung der Ausgabebaugruppen 1,2 die Ausgänge A1,A2 voneinander zu entkoppeln, ist in dem Ausgangspfad des ersten Ausgangs A1 eine zweite Diode D2 angeordnet.

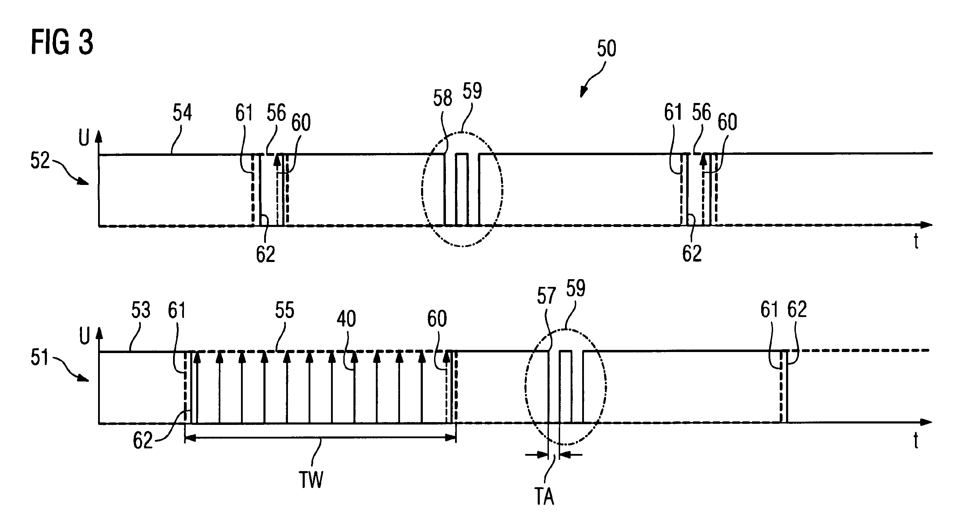

Gemäß FIG 3 ist ein Ablaufdiagramm 50 für die zeitlichen Verläufe des Spannungsverlaufs 51 am ersten Ausgang A1 und des Spannungsverlaufes 52 am zweiten Ausgang A2 der jeweiligen Ausgabebaugruppen 1,2 dargestellt. Die Verläufe sind über die Zeit t abgebildet. Die beiden eingekreisten Bereiche 59 stellen jeweils einen Abschalttest dar. Bei diesem Abschalttest 59 wird entweder der erste Ausgang A1 oder der zweite Ausgang A2 für die Zeitdauer einer Ausschaltzeit TA abgeschaltet.

Bezogen auf den ersten Schalter 11 und dem zweiten Schalter 12 aus FIG 2 wird im Folgenden der Ablauf der Ausgangsspannungen in den Diagrammen von links nach rechts erläutert. Der Spannungsverlauf 51 am ersten Ausgang A1 zeigt einen ersten Bereich 53 in dem der erste Schalter 11 geschlossen ist, parallel dazu zeigt der Spannungsverlauf 52 am zweiten Ausgang einen Bereich 54 in dem ebenfalls der erste Schalter 11 geschlossen ist. Im ersten Spannungsverlauf 51 ist eine steigende Flanke 61 dargestellt. Diese steigende Flanke 61 symbolisiert das Schließen des zweiten Schalters 12 für die Drahtbruchprüfung. Kurz nach dem Schließen des zweiten Schalters 12 öffnet der erste Schalter 11, welches durch eine fallende Flanke 62 im ersten Spannungsverlauf 51 angedeutet ist. Ein Bereich 55 kennzeichnet den Bereich in dem der zweite Schalter 12 fortwährend geschlossen ist, während dieser Wartezeit TW erfolgt mittels des Messmittels 6 eine Drahtbruchprüfung, sollte die Prüfung positiv ausfallen, so wird der Fehler abgesetzt. Die elf durchgezogenen Pfeile 40 stellen symbolisch die zyklische Absetzung der Fehler dar. Innerhalb der Zeitdauer der Wartezeit TW wird durch eine sich wiederholende Auswertung des Stromes I und der daraus gewonnene Messwert dem Prüfkriterium zyklisch unterzogen und immer wieder ein Fehler abgesetzt.

Betrachtet man nun den Spannungsverlauf 52 am zweiten Ausgang A2 so wird deutlich, dass im eingekreisten Abschalttestbereich 59 die Spannung mit einer Abschaltung der Ausgangsspannung 58 auf Null geht. Diese Abschaltung der Ausgangsspannung 58 liegt immer noch im Bereich innerhalb der Zeitdauer der Wartezeit TW, nun wird in der ersten Ausgabebaugruppe 1, dargestellt im Spannungsverlauf 51 am ersten Ausgang A1, der Strom I erneut ausgewertet und der daraus gewonnene Messwert erneut dem Prüfkriterium unterzogen, da aufgrund des geschlossenen zweiten Schalters 12, die erste Ausgangsspannung U1 immer noch am ersten Ausgang A1 anliegt, kann infolge dessen weiterhin ein Strom durch die Last und somit durch die Ausgabebaugruppe 1 fließen. Dies bedeutet, dass bei bestehendem Stromfluss die Absetzung der Fehlers irrtümlich erzeugt wurde, denn ein Drahtbruch kann nicht vorliegen. Daraufhin wird eine Meldung 60, dargestellt als gestrichelter Pfeil, mit der Bedeutung Diagnose in Ordnung abgesetzt. Zum Zuschalten der Spannung U1 über den ersten Schalter 11 wird dieser nun geschlossen und kurz darauf wird zum Abschalten der Drahtbruchprüfung der zweite Schalter 12 geöffnet. Es stellt sich im ersten Spannungsverlauf 51 nun eine Spannung ein, welche ausschließlich über den ersten Schalter 11 an den ersten Ausgang A1 angelegt ist. Im ersten Spannungsverlauf 51 im Abschalttestbereich 59 wird nun eine Abschaltung 57 der Ausgangsspannung U1 für die Zeitdauer TA hervorgerufen.

Die Prüfung der elektrischen Verbindung 4, also das Einschalten des zweiten Schalters 12 für maximal die Zeitdauer der Wartezeit TW und die Abschaltung für die Zeitdauer der Ausschaltzeit TA werden im ersten Spannungsverlauf 51 zyklisch wiederholt, dabei wird ebenso im zweiten Spannungsverlauf 52 der Test für die Drahtbruchprüfung und die Abschaltung der Ausgangsspannung zyklisch wiederholt. Die beiden Ausgabebaugruppen 1,2 prüfen sich also wechselseitig durch jeweilige zyklische Wiederholungen der Drahtbruchprüfung mit der Zeitdauer der Wartezeit TW und den Abschalttest 59 mit der Zeitdauer der Abschaltung TA.

Im zweiten Spannungsverlauf 52 stellt der Bereich 56 den Bereich dar, in der der zweite Schalter 12 geschlossen ist, hier stellt sich der Fall dar, dass mit der steigenden Flanke 61 und nach der fallenden Flanke 62 die am zweiten Ausgang A2 anliegende Spannung allein über den zweiten Schalter 12 an den zweiten Ausgang A2 angelegt ist und somit auch in der zweiten Baugruppe A2 eine Drahtbruchprüfung durchgeführt werden kann. In diesem Fall ist allerdings kein Drahtbruch zu erkennen, wonach sofort die Meldung 60 mit der Bedeutung Diagnose in Ordnung abgesetzt werden kann und mit der abgesetzten Meldung 60 kann wiederum die Umschaltung von Drahtbruchprüfung, also zweiter Schalter 12 geschlossen und erster Schalter 11 geöffnet, auf einen Normalbetrieb, also erster Schalter 11 geschlossen und zweiter Schalter 12 geöffnet, erfolgen.

## Patentansprüche

1. Verfahren zur Diagnose einer elektrischen Verbindung (4) zu einer Last (3), wobei über einen ersten Ausgang (A1) einer ersten Ausgabebaugruppe (1) eine erste Spannung (U1) und über einen zweiten Ausgang (A2) einer zweiten Ausgabebaugruppe (2) eine zweite Spannung (U2) zum Ansteuern der Last (3) bereitstellt wird, wobei
eine Prüfung der elektrischen Verbindung (4) in der ersten Ausgabebaugruppe(1) über den ersten Ausgang (A1)folgendermaßen durchgeführt wird, in der ersten Ausgabebaugruppe (1) wird ein Strom (I) ausgewertet und ein daraus gewonnener Messwert einem Prüfkriterium unterzogen, wobei ein Erfüllen des Prüfkriteriums zunächst in der ersten Ausgabebaugruppe (1) als ein Fehler vermerkt wird, dazu wird in der ersten Ausgabebaugruppe (1) eine Drahtbruchprüfung gestartet mit der Zeitdauer einer Wartezeit (TW), innerhalb der Zeitdauer der Wartezeit (TW)wird die zweite Ausgabebaugruppe (2) derart betrieben wird, dass die zweite Spannung (U2) am zweiten Ausgang (A2) für eine Zeitdauer einer Ausschaltzeit (TA) abgeschaltet wird, nun wird in der ersten Ausgabebaugruppe (1) der Strom (I) erneut ausgewertet und ein daraus gewonnener Messwert erneut dem Prüfkriterium unterzogen, wobei bei fortbestehen des erfüllten Prüfkriteriums, die erste Ausgabebaugruppe (1) eine Störmeldung (41) erzeugt.

2. Verfahren nach Anspruch 1, wobei für den Fall,
dass das Prüfkriterium nicht mehr erfüllt ist, der Fehler verkmerk (40) zurückgenommen wird.

3. Verfahren nach Anspruch 1 oder 2, wobei während der Zeitdauer der Ausschaltzeit (TA) die erste Ausgabebaugruppe (1) die Ansteuerung der Last (3) übernimmt.

4. Verfahren nach einem der Ansprüche 1 bis 3, wobei innerhalb der Zeitdauer der Wartezeit (TW) durch eine sich wiederholende Auswertung des Stromes (I) und der daraus gewonnene Messwert dem Prüfkriterium zyklisch unterzogen wird.

5. Verfahren nach einem der Ansprüche 1 bis 4, wobei als Prüfkriterium eine Unterschreitung des Messwertes unter einen Grenzwert genutzt wird.

6. Verfahren nach einem der Ansprüche 1 bis 5, wobei der Messwert aus einem Spannungsabfall (UR) an einem Widerstand (R) gewonnen wird, welcher in den Strompfad der elektrischen Verbindung (4) geschaltet wird.

7. Verfahren nach einem der Ansprüche 1 bis 6, wobei die Prüfung der elektrischen Verbindung (4) und die Abschaltung für die Zeitdauer der Ausschaltzeit (TA) zyklisch wiederholt werden.

8. Verfahren nach einem der Ansprüche 1 bis 7, wobei die Prüfung der elektrischen Verbindung (4) und die Abschaltung für die Zeitdauer der Ausschaltzeit (TA) von der ersten Ausgabebaugruppe (1) und der zweiten Ausgabebaugruppe (2) wechselseitig durchgeführt werden.

9. Baugruppenanordnung zweier redundant verschalteter Ausgabebaugruppen (1, 2) mit einer ersten Ausgabebaugruppe (1) mit einem ersten Ausgang (A1), welcher zum Ansteuern einer Last (3) mit einer ersten Spannung (U1) ausgestaltet ist, einem ersten Steuermittel (31) zum Ansteuern eines ersten Schaltmittels (10), welches den ersten Ausgang (A1) schaltet, mit einem ersten Messmittel (6) zum Erzeugen eines Messwertes und einer zweiten Ausgabebaugruppe (2) mit einem zweiten Ausgang (A2), welcher zum Ansteuern der Last (3) mit einer zweiten Spannung (U2) ausgestaltet ist, einem zweiten Steuermittel (32) zum Ansteuern eines zweiten Schaltmittels (10), welches den zweiten Ausgang (A2) schaltet, und mit einem zweiten Messmittel (6),
**dadurch gekennzeichnet, dass** das Steuermittel (31, 32) ausgestaltet ist den Messwert einem Prüfkriterium zu unterziehen, wobei ein Erfüllen des Prüfkriteriums zunächst in der ersten Ausgabebaugruppe (1) einen Fehler vermerkt, wobei das Steuermittel (31,32) weiterhin dazu ausgestaltet ist ein Schaltmittel (10) zu steuern und eine Drahtbruchprüfung mit einer Zeitdauer einer Wartezeit (TW) zu starten und innerhalb der Zeitdauer der Wartezeit (TW) das Prüfkriterium zyklisch anzuwenden und wenn vor Ablauf der Zeitdauer der Wartezeit (TW) das Prüfkriterium nicht mehr erfüllt sein sollte, den Fehler verkmerk zurück zunehmen andernfalls bei fortbestehen des erfüllten Prüfkriteriums eine Störmeldung (41) zu erzeugen, wobei jedes Schaltmittel (10) je einen ersten Schalter (11) und je einen zweiten Schalter (12) zum Aufschalten der ersten Spannung (U1) bzw. der zweiten Spannung (U2) auf den ersten Ausgang (A1) bzw. den zweiten Ausgang (A2) aufweist und das erste Steuermittel (10) weiterhin dazu ausgestaltet ist den zweiten Schalter (12) für die Zeitdauer der Wartezeit (TW) zu schließen und den ersten Schalter (11) zu öffnen wobei das zweite Steuermittel (31, 32) dazu ausgestaltet ist nach einem zeitlich vorbestimmten Verhalten die Schalter (11, 12) derart zu Schalten, dass die erste Spannung (U1) am ersten Ausgang (A1) für eine Zeitdauer einer Ausschaltzeit (TA) abgeschaltet wird.

10. Baugruppenanordnung nach Anspruch 9, wobei das Messmittel (6) einen Widerstand (R) aufweist, welcher in einer Reihenschaltung zwischen dem ersten Ausgang (A1) und dem zweiten Schalter (12) angeordnet ist.

11. Baugruppenanordnung nach Anspruch 10, bei welcher parallel zum Widerstand (R) eine erste Diode (D1) zur Begrenzung des Spannungsabfalls angeordnet ist.

## Claims

1. Method for diagnosis of an electrical connection (4) to a load (3), wherein a first voltage (U1) for operating the load (3) is produced via a first output (A1) of a first output assembly (1), and a second voltage (U2) for operating the load (3) is produced via a second output (A2) of a second output assembly (2), wherein
a test of the electrical connection (4) in the first output assembly (1) via the first output (A1) is carried out in the following way, in the first output assembly (1), a current (I) is evaluated and a measured value obtained from it is subjected to a test criterion, wherein satisfaction of the test criterion first of all in the first output assembly (1) is noted as a fault, in addition a wire-break test is started in the first output assembly (1) with the time period of a waiting time (TW), within the time period of the waiting time (TW), the second output assembly (2) is operated such that the second voltage (U2) at the second output (A2) is switched off for a time period of a switched-off time (TA), in the first output assembly (1), the current (I) is now evaluated again and a measured value obtained from it is once again subjected to the test criterion, wherein
if the test criterion which was satisfied is still satisfied, the first output assembly (1) produces a defect message (41).

2. Method according to Claim 1, wherein, if the test criterion is no longer satisfied, the noted fault (40) is canceled.

3. Method according to Claim 1 or 2, wherein the first output assembly (1) operates the load (3) during the time period of the switched-off time (TA).

4. Method according to one of Claims 1 to 3, wherein, within the time period of the waiting time (TW), the measured value obtained from a repeated evaluation of the current (I) is subjected to the test criterion cyclically.

5. Method according to one of Claims 1 to 4, wherein the measured value falling below a limit value is used as a test criterion.

6. Method according to one of Claims 1 to 5, wherein the measured value is obtained from a voltage drop (UR) across a resistance (R) which is connected in the current path of the electrical connection (4).

7. Method according to one of Claims 1 to 6, wherein the test of the electrical connection (4) and the switching-off process are repeated cyclically for the time period of the switched-off time (TA).

8. Method according to one of Claims 1 to 7, wherein the test of the electrical connection (4) and the switching-off for the time period of the switched-off time (TA) are carried out alternately by the first output assembly (1) and by the second output assembly (2).

9. Assembly arrangement of two redundantly connected output assemblies (1, 2) having a first output assembly (1) having a first output (A1), which is designed to operate a load (3) with a first voltage (U1), having a first control means (31) for operating a first switching means (10) which switches the first output (A1), and having a first measurement means (6) for production of a measured value and a second output assembly (2) having a second output (A2), which is designed to operate the load (3) with a second voltage (U2), having a second control means (32) for operating a second switching means (10) which switches the second output (A2), and having a second measurement means (6),
**characterized in that** the control means (31, 32) is designed to subject the measured value to a test criterion, wherein satisfaction of the test criterion first of all in the first output assembly (1) is noted as a fault, wherein the control means (31, 32) is furthermore designed to control a switching means (10) and to start a wire-break test with a time period of a waiting time (TW) and to apply the test criterion cyclically within the time period of the waiting time (TW) and, if the test criterion is no longer satisfied, before the time period of the waiting time (TW) has elapsed, the noted fault is canceled, otherwise a defect message (41) can be produced if the test criterion is still satisfied, wherein each switching means (10) has a respective first switch (11) and a respective second switch (12) for connection of the first voltage (U1) and the second voltage (U2), respectively, to the first output (A1) and the second output (A2), respectively, and the first control means (10) is furthermore designed to close the second switch (12) for the time period of the waiting time (TW), and to open the first switch (11), wherein the second control means (31, 32) is designed to switch the switches (11, 12) after a response which is predetermined in time, such that the first voltage (U1) at the first output (A1) is switched off for a time period of a switched-off time (TA).

10. Assembly arrangement according to Claim 9, wherein the measurement means (6) has a resistance (R) which is arranged connected in series between the first output (A1) and the second switch (12).

11. Assembly arrangement according to Claim 10, in which a first diode (D1) is arranged in parallel with the resistance (R), in order to limit the voltage drop.

## Revendications

1. Procédé de diagnostic d'une connexion ( 4 ) électrique à une charge ( 3 ), dans lequel on applique pour commander la charge ( 3 ) une première tension ( U1 ) par une première sortie ( A1 ) à un premier module ( 1 ) de sortie et une deuxième tension ( U2 ) par une deuxième sortie ( A2 ) à un deuxième module ( 2 ) de sortie, dans lequel
on effectue un contrôle de la connexion ( 4 ) électrique dans le premier module ( 1 ) de sortie par la première sortie ( A1 ) en évaluant un courant ( I ) dans le premier module ( 1 ) de sortie et en soumettant une valeur de mesure qui en est obtenue à un critère de contrôle, dans lequel une satisfaction du critère de contrôle d'abord dans le premier module ( 1 ) de sortie est noté comme un défaut, un contrôle de rupture de fil étant lancé à cet effet dans le premier module ( 1 ) de sortie avec la durée d'un temps ( TW ) d'attente, pendant la durée du temps ( TW ) d'attente, le deuxième module ( 2 ) de sortie est mis en fonctionnement de manière à ce que la deuxième tension ( U2 ) a la deuxième sortie ( A2 ) soit interrompue pendant une durée d'un temps ( TA ) de déconnexion, le courant ( I ) est évalué à nouveau maintenant dans le premier module ( 1 ) de sortie et une valeur de mesure qui en est obtenue est soumise à nouveau au critère de contrôle, le premier module ( 1 ) de sortie produisant, si le critère de contrôle continue a être satisfait, un message ( 41 ) de panne.

2. Procédé suivant la revendication 1, dans lequel, dans le cas où le critère de contrôle, n'est plus satisfait on revient sur la notation de défaut.

3. Procédé suivant la revendication 1 ou 2, dans lequel, pendant la durée du temps ( TA ) de déconnexion, le premier module ( 1 ) de sortie prend en charge la commande de la charge ( 3 ).

4. Procédé suivant l'une des revendications 1 à 3, dans lequel dans la durée du temps ( TW ) d'attente, on soumet cycliquement au critère de contrôle par une évaluation répétée du courant ( I ) et de la valeur de mesure qui en est obtenue.

5. Procédé suivant l'une des revendications 1 à 4, dans lequel on utilise comme critère de contrôle le fait que la valeur de mesure passe en dessous d'une valeur limite.

6. Procédé suivant l'une des revendications 1 à 5, dans lequel on obtient la valeur de mesure à partir d'une chute ( UR ) de tension sur une résistance qui est montée dans le trajet de courant de la connexion ( 4 ) électrique.

7. Procédé suivant l'une des revendications 1 à 6, dans lequel on répète de manière cyclique pendant la durée du temps ( TA ) de déconnexion le contrôle de la connexion ( 4 ) électrique et la déconnexion.

8. Procédé suivant l'une des revendications 1 à 7, dans lequel on effectue en alternance le contrôle de la connexion ( 4 ) électrique et la déconnexion pendant la durée du temps ( TA ) de déconnexion du premier module ( 1 ) de sortie et du deuxième module ( 2 ) de sortie.

9. Agencement de deux modules ( 1, 2 ) de sortie, montés de manière redondante, comprenant un premier module ( 1 ) de sortie ayant une première sortie ( A1 ) qui est conformée pour commander une charge ( 3 ) par une première tension ( U1 ), un premier moyen ( 31 ) de commande pour commander un premier moyen ( 30 ) de commutation, qui branche la première sortie ( A1 ), un premier moyen ( 6 ) de mesure d'une valeur de mesure et un deuxième module ( 2 ) de sortie ayant une deuxième sortie ( A2 ) qui est conformée pour commander la charge ( 3 ) par une deuxième tension ( U2 ), un deuxième moyen ( 32 ) de commande d'un deuxième moyen ( 10 ) de commutation, qui branche la deuxième sortie ( A2 ), et un deuxième moyen ( 6 ) de mesure,
**caractérisé en ce que** le moyen ( 31, 32 ) de commande est conformé pour soumettre la valeur de mesure à un critère de contrôle, une satisfaction du critère de contrôle étant notée d'abord dans le premier module ( 1 ) de sortie comme un défaut, le moyen ( 31, 32 ) de commande étant conformé en outre pour commander un moyen ( 10 ) de commutation et pour lancer un contrôle de rupture de fil d'une durée d'un temps ( TW ) d'attente et, dans la durée du temps ( TW ) d'attente, pour appliquer cycliquement le critère de contrôle et, si avant l'expiration de la durée du temps ( TW ) d'attente, le critère de contrôle ne devait plus être satisfait, pour revenir sur la notation du défaut, dans le cas contraire, si le critère de contrôle continue à être satisfait, pour produire un message ( 41 ) de panne, chaque moyen ( 10 ) de commutation ayant respectivement un premier commutateur ( 11 ) et respectivement un deuxième commutateur ( 12 ) pour appliquer la première tension ( U1 ) ou la deuxième tension ( U2 ) à la première sortie ( A1 ) ou à la deuxième sortie ( A2 ) et le premier moyen ( 10 ) de commande étant en outre conformé pour fermer le deuxième commutateur ( 12 ) pendant la durée du temps ( TW ) d'attente et pour ouvrir le deuxième commutateur ( 11 ), le deuxième moyen ( 31, 32 ) de commande étant conformé pour, après un laps de temps déterminé à l'avance, commuté les commutateurs ( 11, 12 ) de manière à interrompre l'application d'une première tension ( U1 ) à la première sortie ( A1 ) pendant une durée d'un temps ( Ta ) de déconnexion.

10. Agencement de modules suivant la revendication 9, dans lequel le moyen ( 6 ) de mesure comporte une résistance ( R ) qui est montée suivant un circuit série entre la première sortie ( A1 ) et le deuxième commutateur ( 12 ).

11. Agencement de modules suivant la revendication 10, dans lequel une première diode ( D1 ) est montée en parallèle à la résistance ( R ) pour la limitation de la chute de tension.
